# EUROPEAN PATENT SPECIFICATION

(11) **EP 1 715 476 B1**
(45) Date of publication and mention of the grant of the patent: **20.08.2008**
(21) Application number: 06076231.7
(22) Date of filing: 13.01.2005
(51) Int. Cl.: G10L 19/02

(54) **Low-bitrate encoding/decoding method and system**
Verfahren und System zur Kodierung/Dekodierung mit niedriger Übertragungsrate
Procédé et système d'encodage/de décodage à faible débit binaire

(30) Priority: 25.06.2004 KR 20040048036
(43) Date of publication of application: 25.10.2006
(62) Divisional of application: 05250132.7
(73) Proprietor: Samsung Electronics Co., Ltd., Suwon-si, Gyeonggi-Do (KR)
(72) Inventor: Oh, Eunmi, Seocho-gu Seoul (KR); Kim, Junghoe, Gangseo-gu Seoul (KR); Kim, Sangwook, Seocho-gu Seoul (KR); Egorov, Andrey St. Petersburg Academy of, 190000 St. Petersburg (RU); Porov, Anton St. Petersburg Academy of, 190000 St. Petersburg (RU); Osipov, Konstantin St. Petersburg Academy of, 190000 St. Petersburg (RU); Kudryashov, Boris St. Petersburg Academy of, 190000 St. Petersburg (RU)
(74) Representative: Greene, Simon Kenneth

(56) References cited:
- JOHNSTON J D: "TRANSFORM CODING OF AUDIO SIGNALS USING PERCEPTUAL NOISE CRITERIA" IEEE JOURNAL ON SELECTED AREAS IN COMMUNICATIONS, IEEE INC. NEW YORK, US, vol. 6, no. 2, 1 February 1988 (1988-02-01), pages 314-323, XP002003779 ISSN: 0733-8716
- BRANDENBURG K ET AL: "ISO-MPEG-1 AUDIO: A GENERIC STANDARD FOR CODING OF HIGH-QUALITY DIGITAL AUDIO" JOURNAL OF THE AUDIO ENGINEERING SOCIETY, AUDIO ENGINEERING SOCIETY. NEW YORK, US, vol. 42, no. 10, October 1994 (1994-10), pages 780-792, XP000978167 ISSN: 0004-7554
- TANG B ET AL: "Spectral analysis of subband filtered signals" ACOUSTICS, SPEECH, AND SIGNAL PROCESSING, 1995. ICASSP-95., 1995 INTERNATIONAL CONFERENCE ON DETROIT, MI, USA 9-12 MAY 1995, NEW YORK, NY, USA,IEEE, US, vol. 2, 9 May 1995 (1995-05-09), pages 1324-1327, XP010151556 ISBN: 0-7803-2431-5

## Description

The present invention relates to an encoding/decoding method and system, and more particularly, to a low bitrate encoding/decoding method and system that can efficiently compress data at a low bitrate and thus provide a high quality audio signal.
A waveform including information is originally an analog signal which is continuous in amplitude and time. Accordingly, analog-to-digital (A/D) conversion is required to represent a discrete waveform. A/D conversion comprises two distinct processes: sampling and quantizing. Sampling refers to the process of changing a signal continuous in time into a discrete signal, and quantizing refers to the process of limiting the possible number of amplitudes to a finite value, that is, the process of transforming an input amplitude x(n) at time 'n' into an amplitude y(n) taken from a finite set of possible amplitudes.

With a recent development in digital signal processing technologies, there have been developed and widely used techniques for storing/restoring an audio signal where an analog signal is converted into pulse code modulation (PCM) data, a digital signal, through sampling and quantizing processes, and the converted signal is stored in recording/storing media, such as a compact disc (CD) and a digital audio tape (DAT), to allow users to play back the stored signal. While this digital storing/restoring technology has much improved in sound quality and storage term as compared to an analog source, such as a long-play record (LP) or tape, there has been a problem in data storage and transmission due to a huge amount of digital data.

Here, a CD is a medium for storing data obtained by sampling an analog stereo (left/right) audio signal at a rate of 44,100 per sec and a 16bit resolution, which can be played back. For example, in case of converting an analog audio signal for presenting a 60sec music into 2-channel digital audio data with CD audio quality, the analog audio signal is converted into digital data with a sampling rate of 44.1 kHz for 16 bits. Thus, a 60sec music requires 10.58Mbyte (44.1 kHz * 16 bits * 2 * 60). Accordingly, transmitting a digital audio signal via a transfer channel needs a high transfer bitrate.

In order to overcome this problem, the differential pulse code modulation (DPCM) or adaptive differential pulse code modulation (ADPCM), which was developed to compress digital audio signals, has been employed to reduce the data size, but there has been a problem in that significant differences in efficiency occur depending on types of signals. Recently, ISO (International Standard Organization) MPEG/audio (Moving Pictures Expert Group) algorithm or Dolby AC-2/AC-3 algorithm has employed a psychoacoustic model to reduce the data size. These algorithms efficiently reduce the data size irrespective of types of signals.

In conventional audio compression algorithms such as MPEG-1/audio, MPEG-2/audio, or AC-2/AC-3, a time-domain signal is divided into subgroups to be transformed into a frequency-domain signal. This transformed signal is scalar-quantized using the psychoacoustic model. This quantization technique is simple but not optimum although input samples are statistically independent. Of course, statistically dependent input samples are more problematic. In order to solve this problem, a lossless encoding, such as an entropy encoding, is performed, or an encoding operation is performed including an adaptive quantization algorithm. Accordingly, such an algorithm requires very complicated procedures as compared to an algorithm where only PCM data is encoded, and a bitstream includes additional information for compressing signals as well as quantized PCM data.

MPEG/audio or AC-2/AC-3 standards present as high audio quality as a CD at bitrates of 64-384Kbps, which are a sixth or an eighth of conventional digital encoding bitrates. Therefore, MPEG/audio standards will play a significant role in audio signal storage and transfer in a multimedia system, such as Digital Audio Broadcasting (DAB), internet phone, or Audio on Demand (AOD).

These conventional techniques are relatively useful for encoders. However, with the advent of mobile multimedia applications, there has been required a low bitrate audio encoding/decoding method and system that can perform both encoding and various functions at low bitrates.

An example of a known transform coder is disclosed by J.D. Johnston: "Transform coding of Audiosignals using Perceptual Noise Criteria, "IEEE Journal on Selected Areas in Communications, IEEE, Vol. 6, 1. February 1988, pages 314-323.

The present invention as claimed in the appended claims provides a low bitrate audio encoding/decoding method and system that can effectively compress data at a relatively low bitrate and thus provide a high quality audio signal using algorithms for reducing and recovering frequency components.

According to an aspect of the present invention, there is provided a low-bitrate encoding system comprising: a time-frequency transform unit transforming an input time-domain audio signal into a frequency-domain audio signal; a frequency component processor unit decimating frequency components in the frequency-domain audio signal; a psychoacoustic model unit modeling the received time-domain audio signal on the basis of human auditory characteristics, and calculating encoding bit allocation information; a quantizer unit quantizing the frequency-domain audio signal input from the frequency component processor unit to have a bitrate based on the encoding bit allocation information input from the psychoacoustic model unit; and a lossless encoder unit encoding the quantized audio signal losslessly, and outputting the encoded audio signal in a bitstream format.

The data signal may include one of the audio and image signals. According to another aspect of the present invention, there is provided a low-bitrate encoding method comprising: transforming an input time-domain audio signal into a frequency-domain audio signal; decimating frequency components in the frequency-domain audio signal; modeling the received time-domain audio signal on the basis of human auditory characteristics, and calculating encoding bit allocation information; quantizing the frequency-domain audio signal input through the decimating of frequency components to have a bitrate based on the encoding bit allocation information input through the modeling of the audio signal; and encoding the quantized audio signal losslessly and outputting the encoded audio signal in a bitstream format.

According to another aspect of the present invention, there is provided a low-bitrate decoding system comprising: a lossless decoder unit decoding an input bitstream losslessly and outputting the decoded audio signal; an inverse quantizer unit recovering an original signal from the decoded audio signal; a frequency component processor unit increasing frequency coefficients of the audio signal in the inversely quantized frequency-domain audio signal; and a frequency-time transform unit transforming the frequency-domain audio signal input from the frequency component processor unit into a time-domain audio signal.

According to another aspect of the present invention, there is provided a low-bitrate decoding method comprising: decoding an input bitstream losslessly and outputting the decoded audio signal; recovering an original signal from the decoded audio signal; increasing frequency coefficients of the audio signal in the recovered frequency-domain audio signal; and transforming the frequency-domain audio signal input through the increasing of frequency coefficients into a time-domain audio signal.
FIG. 1 is a block diagram showing a construction of a low bitrate audio encoding system;
FIG. 2 is a block diagram showing a construction of the frequency component processor unit 110 shown in FIG. 1;
FIG. 3 is a block diagram showing constructions of filter and decimation units shown in FIG. 2;
FIG. 4 is a block diagram showing another construction of the frequency component processor unit 110 shown in FIG. 1;
FIG. 5 is a flowchart showing an operation of a low bitrate audio encoding system according to the present invention shown in FIG. 1;
FIG. 6 is a flowchart showing an example of operation 510 shown in FIG. 5;
FIG. 7 is a flowchart showing another example of operation 510 shown in FIG. 5;
FIGS. 8A through 8D show an example of signal variations based on frequency signal processing in an embodiment of a low bitrate audio encoding system according to the present invention;
FIGS. 9A through 9D show another example of signal variations based on frequency signal processing in an embodiment of a low bitrate audio encoding system according to the present invention;
FIG. 10 is a block diagram showing a construction of a lossless audio decoding system according to the present invention;
FIG. 11 is a block diagram showing a construction of the frequency component processor unit 1040 shown in FIG. 10;
FIG. 12 is a block diagram showing another construction of the frequency component processor unit 1040 shown in FIG. 10;
FIG. 13 is a flowchart showing an operation of a lossless audio decoding system according to the present invention shown in FIG. 10;
FIG. 14 is a flowchart showing an example of operation 1340 shown in FIG. 13;
FIG. 15 is a flowchart showing another example of operation 1340 shown in FIG. 13;
FIGS. 16A and 16B show an example of an audio signal for a predetermined subband in an encoding operation and in a decoding operation, respectively; and
FIGS. 17A and 17B show another example of an audio signal for a predetermined subband in an encoding operation and in a decoding operation, respectively.

Exemplary embodiments according to the present invention will now be described in detail with reference to the accompanying drawings.

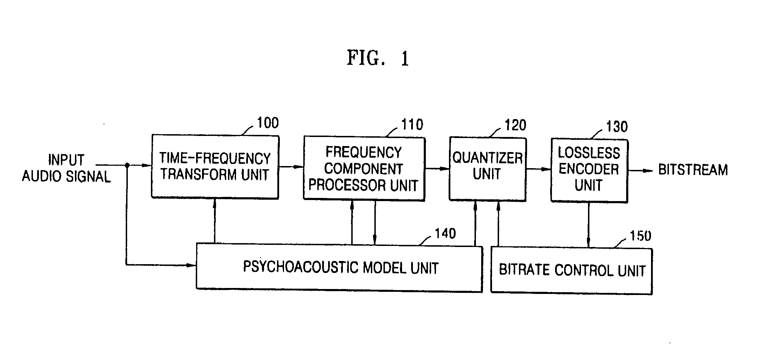

FIG. 1 is a block diagram showing a construction of a low bitrate audio encoding system. The system comprises a time-frequency transform unit 100, a frequency component processor unit 110, a quantizer unit 120, a lossless encoder unit 130, a psychoacoustic model unit 140, and a bitrate control unit 150.

The time-frequency transform unit 100 transforms a time-domain audio signal into a frequency-domain audio signal. A modified discrete cosine transform (MDCT) may be used to transform a time-domain signal into a frequency-domain signal.

The frequency component processor unit 110 receives a frequency-domain audio signal from the time-frequency transform unit 100, and transforms N frequency coefficients into N' frequency coefficients in the frequency-domain audio signal, where N' is less than N. This transform may be regarded as a non-linear and non-invertible transform. The frequency component processor unit 110 divides frequency components into subbands. An integer MDCT is preferably used to divide frequency components into subbands.

In order to remove perceptual redundancy based on human auditory characteristics, the psychoacoustic model unit 140 transforms an input audio signal into a frequency-domain spectrum, and determines encoding bit allocation information on signals not to be perceived by the human ear with respect to each of the subbands in the frequency component processor unit 110. The psychoacoustic model unit 140 calculates a masking threshold for each of the subbands, which is encoding bit allocation information, using a masking phenomenon resulting from interaction between predetermined subbands signals divided in the frequency component processor unit 110. The psychoacoustic model unit 140 outputs the calculated encoding bit allocation information to the quantizer unit 120. In addition, the psychoacoustic model unit 140 determines window switching based on a perceptual energy, and outputs the window switching information to the time-frequency transform unit 100.

The quantizer unit 120 quantizes a frequency-domain audio signal, which is input from the frequency component processor unit 110 and transformed into N' frequency components, to have a bitrate based on the encoding bit allocation information input from the psychoacoustic model unit 140. That is, frequency signals in each of the subbands are scalar-quantized so that a quantization noise amplitude in each of the subbands is less than a masking threshold, which is encoding bit allocation information, and thus the human ear cannot perceive the signals. Using a noise-to-mask ratio (NMR), which is the ratio between the masking threshold calculated in the psychoacoustic model unit 140 and noise generated in each of the subbands, a quantization is performed so that an NMR value in each of the subbands is not greater than 0dB. The NMR value not greater than 0dB indicates that the masking value is higher than the quantization noise, which means that the human ear cannot perceive the quantization noise.

The lossless encoder unit 130 losslessly encodes the quantized audio signal received from the quantizer unit 120, and outputs the encoded signal in a bitstream format. The lossless encoder unit 130 can efficiently compress signals using a lossless coding algorithm, such as a Huffman coding or arithmetic coding algorithm.

The bitrate control unit 150 receives information on the bitrate of the bitstream from the lossless encoder unit 130, and outputs a bit allocation parameter suitable for the bitrate of the bitstream to be output to the quantizer unit 120. That is, the bitrate control unit 150 minutely controls the bitrate of the bitstream to be output and outputs the bitstream at a desired bitrate.

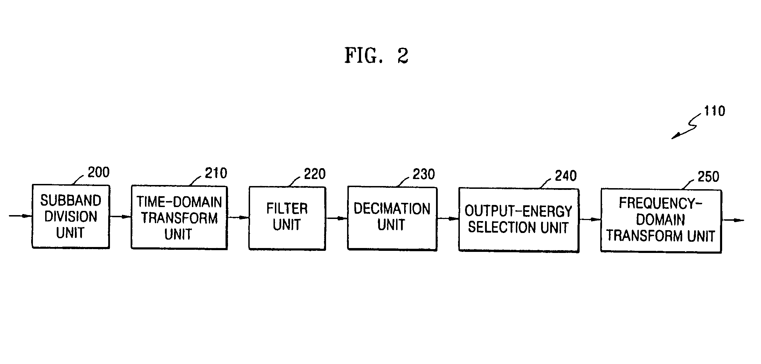

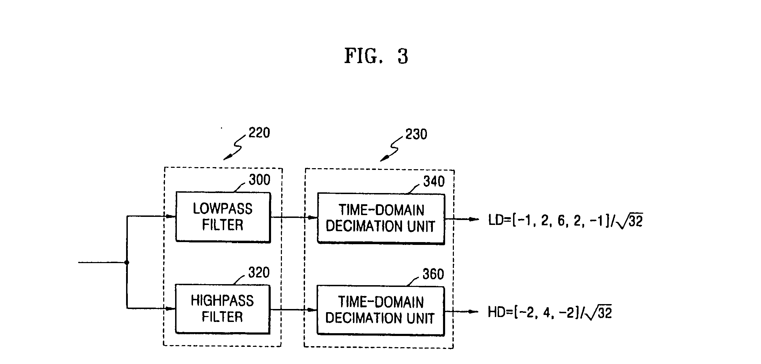

FIG. 2 is a block diagram showing a construction of the frequency component processor unit 110 shown in FIG. 1. FIG. 3 is a block diagram showing constructions of filter and decimation units shown in FIG. 2. The frequency component processor unit 110 comprises a subband division unit 200, a time-domain transform unit 210, a filter unit 220, a decimation unit 230, an output-energy selection unit 240, and a frequency-domain transform unit 250.

The subband division unit 200 divides an audio signal, which is input from the time-frequency transform unit 100 and transformed into a frequency, into subbands.

The time-domain transform unit 210 transforms the audio signal, which is divided into subbands, into a time-domain audio signal corresponding to each of the subbands.

The filter unit 220 filters the time-domain audio signal input from the time-domain transform unit 210. The filter unit 220 consists of a lowpass filter 300 and a highpass filter 320. The lowpass filter 300 extracts a reference signal composed of low frequency components from the time-domain audio signal, and the highpass filter 320 extracts a detailed signal composed of high frequency components from the time-domain audio signal.

The time-domain audio signal, which is filtered in the filter unit 220, is decimated by a predetermined range in the decimation unit 230. The decimation unit 230 consists of a time-domain decimation unit 340, which reduces by half in a time domain the reference signal input from the lowpass filter 300, and a time-domain decimation unit 360, which reduces by half in a time domain the reference signal input from the highpass filter 320. While the example in FIG. 3 illustrates a time-domain signal reduced by half in a time domain, the decimation range of a time-domain signal may be differently set.

The output-energy selection unit 240 determines which one has a higher output energy among the reference and detailed signals which are reduced in a time domain by means of the decimation unit 230. That is, the output-energy selection unit 240 compares the output energy between the reference and detailed signals, and selects only a signal with a higher output energy.

The frequency-domain transform unit 250 receives the selected time-domain audio signal from the output-energy selection unit 240, and transforms the received signal into a frequency-domain audio signal.

Accordingly, it is possible to reduce frequency components since only any one of the reference and detailed signals is selected.

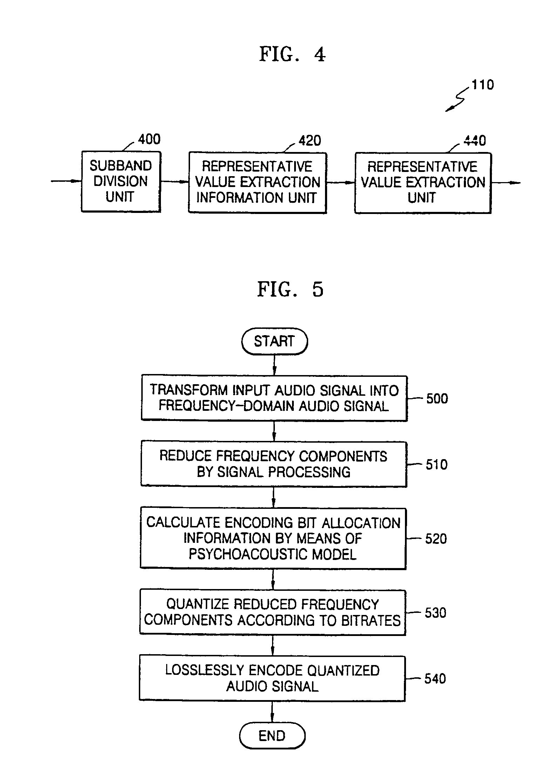

FIG. 4 is a block diagram showing another construction of the frequency component processor unit 110 shown in FIG. 1.

A subband division unit 400 divides an audio signal, which is input from the time-frequency transform unit 100 and transformed into a frequency, into subbands.

A representative value extraction information unit 420 provides prior information on how to extract a representative value from each of the subbands divided in the subband division unit 400. For instance, a representative value is selected for five frequency components in each of the subbands, and there is provided representative value extraction information on whether a maximum value is to be determined to be the representative value.

A representative value extracting unit 440 receives each of the subbands signals divided in the subband division unit 400 and information on the representative value extraction from the representative value extraction information unit 420, and extracts only a representative value corresponding to the information. Accordingly, it is possible to reduce frequency components since only a frequency component corresponding to a certain representative value is selected from each of the subbands.

While the example in FIG. 4 illustrates an audio signal, the frequency component processor unit 110 can handle a data signal including an image signal as well as an audio signal by using the aforementioned constructions.

FIG. 5 is a flowchart showing an operation of a low bitrate audio encoding system according to the present invention shown in FIG. 1.

In operation 500, a time-domain audio signal input from the outside is transformed into a frequency-domain audio signal. In operation 510, a portion of frequency components are reduced in a frequency-domain audio signal. That is, N frequency coefficients are transformed into N' frequency coefficients in the frequency-domain audio signal, where N' is less than N. In operation 520, encoding bit allocation information is calculated by means of a psychoacoustic model. In operation 530, reduced frequency components are quantized according to the encoding bit allocation information. In operation 540, the quantized audio signal is encoded.

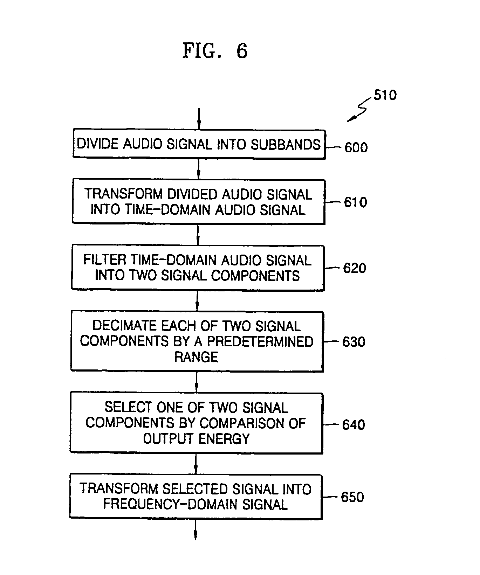

FIG. 6 is a flowchart showing an example of operation 510 shown in FIG. 5.

In operation 600, the frequency-domain audio signal input through operation 500 is divided into subbands.

In operation 610, the audio signal divided into subbands is transformed into a time-domain audio signal corresponding to each of the subbands.

In operation 620, the time-domain audio signal is filtered into two signal components. The two signal components refer to a reference signal, which is composed of low frequency components extracted from the time-domain audio signal by use of a lowpass filter, and a detailed signal, which is composed of high frequency components extracted from the time-domain audio signal by use of a highpass filter.

In operation 630, each of the time-domain audio signal components divided in operation 620 is decimated by a predetermined range. For instance, as shown in the decimation unit 230 of FIG. 3, the reference signal input from the lowpass filter is reduced by half in a time domain, and a detailed signal input from the highpass filter is reduced by half in a time-domain. While the present example illustrates the reference and detailed signals reduced by half in a time domain, the decimation range of the reference and detailed signals may be differently set.

In operation 640, it is determined which one has a higher output energy among the reference and detailed signals which are reduced in a time domain in operation 630. That is, the output energy is compared between the reference and detailed signals, and only a signal with a higher output energy is selected.

In operation 650, the selected time-domain audio signal is received and transformed into a frequency-domain audio signal. That is, only any one of the reference and detailed signals is selected and transformed into a frequency-domain signal, whereby frequency components of a first input audio signal can be reduced.

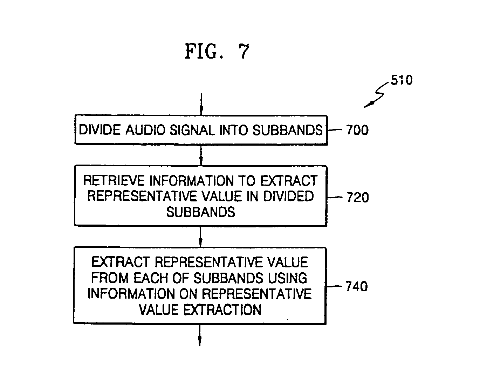

FIG. 7 is a flowchart showing another example of operation 510 shown in FIG. 5.

In operation 700, a frequency-domain audio signal input through operation 500 is divided into subbands.

In operation 720, information on how to extract a representative value from each of the subbands divided in operation 700 is retrieved. For instance, a representative value is selected for five frequency components in each of the subbands, and there is provided representative value extraction information on whether a maximum value is to be determined to be the representative value.

In operation 740, each of the subbands signals divided in operation 700 and information on the representative value extraction in operation 720 are received, and only a representative value corresponding to the information is extracted. Accordingly, it is possible to reduce frequency components since only a frequency component corresponding to a certain representative value is selected from each of the subbands.

While the example in FIG. 7 illustrates an audio signal, the frequency component processor unit 110 can handle a data signal including an image signal as well as an audio signal by using the aforementioned constructions.

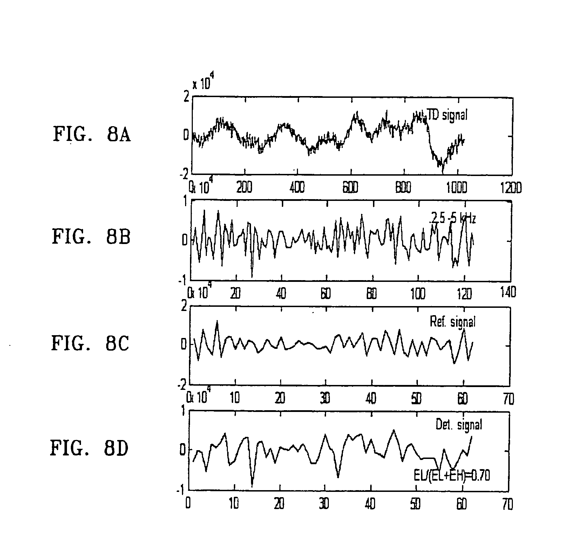

FIGS. 8A through 8D show an example of signal variations based on frequency signal processing in an embodiment of a low bitrate audio encoding system according to the present invention.

FIG. 8A shows a time-domain input audio signal, FIG 8B shows an audio signal in a range of 2.5 to 5kHz which is divided in the subband division unit 200 of a frequency component processor unit 110, FIG. 8C shows a reference signal divided in the filter unit 220 of the frequency component processor unit 110, and FIG. 8D shows a detailed signal divided in the filter unit 220 of the frequency component processor unit 110.

In FIG. 8D, EL/(EL+EH) = 0.70 means that the reference signal occupies 70% of the whole signals. That is, in this case, since the reference signal has a higher energy ratio than the detailed signal, the reference signal will be selected in the output-energy selection unit 230 of the frequency component processor unit 110.

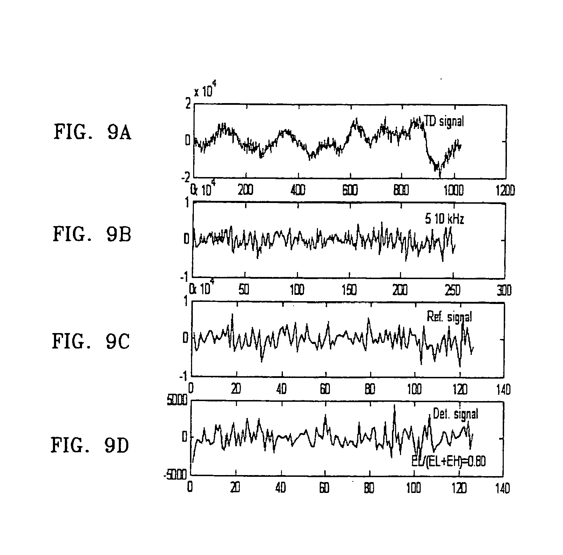

FIGS. 9A through 9D show another example of signal variations based on frequency signal processing in an embodiment of a low bitrate audio encoding system according to the present invention.

FIG. 9A shows a time-domain input audio signal, FIG 9B shows an audio signal in a range of 5 to 10kHz which is divided in the subband division unit 200 of a frequency component processor unit 110, FIG. 9C shows a reference signal divided in the filter unit 220 of the frequency component processor unit 110, and FIG. 9D shows a detailed signal divided in the filter unit 220 of the frequency component processor unit 110.

In FIG. 9D, EL/(EL+EH) = 0.80 means that the reference signal occupies 80% of the whole signals. That is, in this case, since the reference signal has a higher energy ratio than the detailed signal, the reference signal will be selected in the output-energy selection unit 230 of the frequency component processor unit 110.

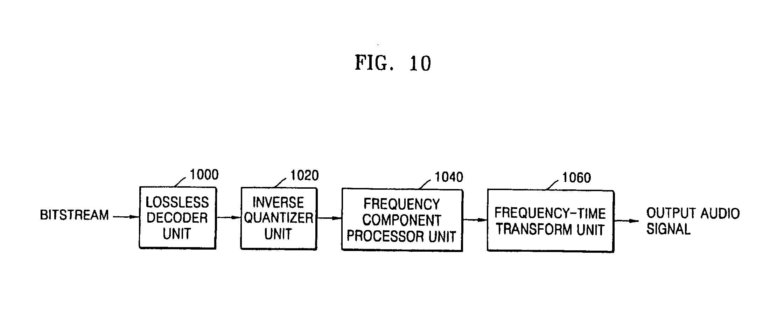

FIG. 10 is a block diagram showing a construction of a lossless audio decoding system according to the present invention. The system comprises a lossless decoder unit 1000, an inverse quantizer unit 1020, a frequency component processor unit 1040, and a frequency-time transform unit 1060.

The lossless decoder unit 1000 performs a process reverse to that of the lossless encoder unit 130. Accordingly, a received encoded bitstream is decoded, and the decoded audio signal is output to the inverse quantizer unit 1020. That is, the lossless decoder unit 1000 decodes additional information, which includes the quantization step size and a bitrate allocated to each band, and the quantized data in a layered bitstream according to the order in which the layer is generated. The lossless decoder unit 1000 can decode signals using an arithmetic decoding or Huffman decoding algorithm.

The inverse quantizer unit 1020 recovers an original signal from the decoded quantization step size and quantized data.

The frequency component processor unit 1040 transforms N' frequency coefficients, which were reduced in the frequency component processor unit 110 as described in FIG. 1, into the original N frequency coefficients through frequency component processing.

The frequency-time transform unit 1060 transforms the frequency-domain audio signal back into the time-domain signal to allow a user to play the audio signal.

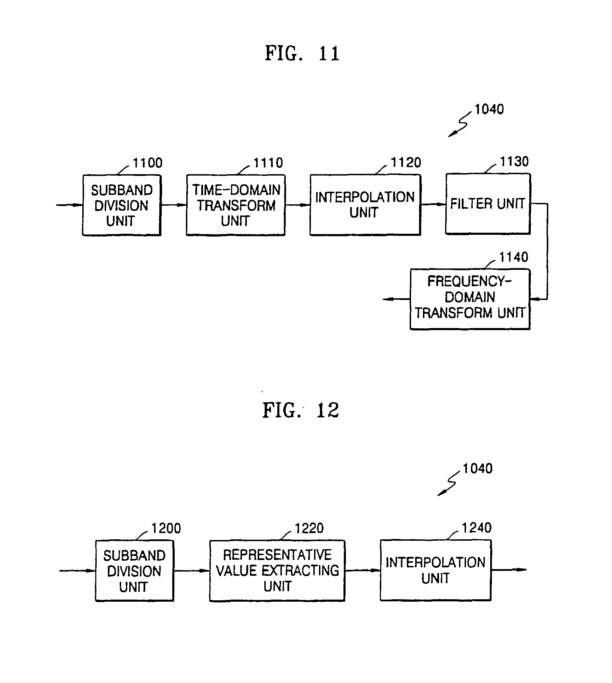

FIG. 11 is a block diagram showing a construction of the frequency component processor unit 1040 shown in FIG. 10. The frequency component processor unit 1040 comprises a subband division unit 1100, a time-domain transform unit 1110, an interpolation unit 1120, a filter unit 1130, and a frequency-domain transform unit 1140.

The subband division unit 1100 divides an audio signal, which is input from the lossless decoder unit 1000 and transformed into a frequency, into subbands.

The time-domain transform unit 1110 transforms the audio signal, which is divided into subbands, into a time-domain audio signal corresponding to each of the subbands.

The interpolation unit 1120 receives the time-domain audio signal from the time-domain transform unit 1110, and interpolates the signal, which is decimated by a predetermined range in the decimation unit 230 of FIG. 2, by the decimated range. For instance, since the decimation unit 230 in FIG. 3 reduces the reference or detailed signal by half, the interpolation unit 1120 increases the time-domain signal by double. While the example in FIG. 11 illustrates a time-domain signal interpolated by double, the interpolation range of a time-domain signal may be differently set. In addition, the interpolation unit 1120 may interpolate signals using additional information of an interpolation factor.

The filter unit 1130 detects whether the time-domain audio signal input from the interpolation unit 1120 is the reference signal composed of low frequency components within the time-domain audio signal in FIG. 3, or the detailed signal composed of high frequency components within the time-domain audio signal in FIG. 3. The filter unit 1130 detects by means of additional information whether it is a reference signal or a detailed signal.

The frequency-domain transform unit 1140 receives the reference or detailed signal from the filter unit 1130, and transforms the input time-domain audio signal into a frequency-domain signal.

FIG. 12 is a block diagram showing another construction of the frequency component processor unit 1040 shown in FIG. 10. The frequency component processor unit 1040 comprises a subband division unit 1200, a representative value extracting unit 1220, and an interpolation unit 1240.

The subband division unit 1200 divides an audio signal, which is input from the lossless decoder unit 1000 and transformed into a frequency, into subbands.

The representative value extracting unit 1220 extracts a representative value from an audio signal divided into subbands.

The interpolation unit 1240 receives a representative value from the representative value extracting unit 1220, and interpolates frequency components into each of the subbands divided in the subband division unit 1200. The interpolation unit 1240 performs an interpolating operation by using a predetermined parameter or additional information in a bitstream received from a low bitrate audio encoding system. Referring to the example in FIG. 4, in case of selecting a representative value for five frequency components in each of the subbands, four unselected frequency components in each of the subbands may be set to have the same value as the representative value. In addition, the four unselected frequency components may be differently interpolated depending on distances from the frequency component having the representative value. The representative value may be determined to be the maximum value or the mean value of the frequency components.

While the example in FIG. 12 illustrates an audio signal, the frequency component processor unit 110 can handle a data signal including an image signal as well as an audio signal by using the aforementioned constructions.

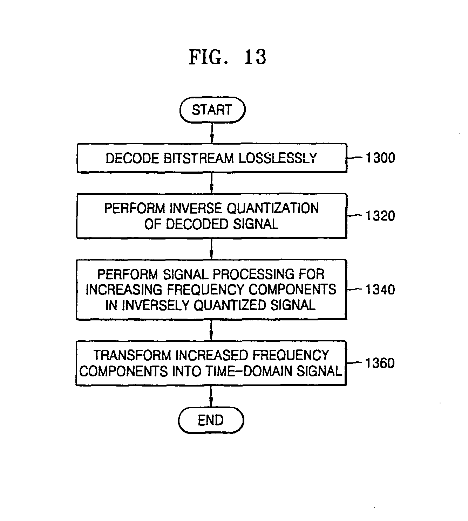

FIG. 13 is a flowchart showing an operation of a lossless audio decoding system according to the present invention shown in FIG. 10.

Operation 1300 performs a process reverse to that of operation 540 of FIG. 5, where the quantized audio signal is losslessly encoded. Accordingly, a received encoded bitstream is decoded, and the decoded audio signal is output. That is, in operation 1300, additional information, which includes the quantization step size and a bitrate allocated to each band, and the quantized data are decoded in a layered bitstream according to the order in which the layer is generated. In operation 1300, a decoding process is performed using an arithmetic decoding or Huffman decoding algorithm.

In operation 1320, an original signal is recovered from the decoded quantization step size and quantized data.

In operation 1340, the inversely quantized signal is increased from N' frequency coefficients reduced in operation 510 of FIG. 5 to the original N frequency coefficients through frequency component processing.

In operation 1360, the frequency-domain audio signal is transformed back into the time-domain signal to allow a user to play the audio signal.

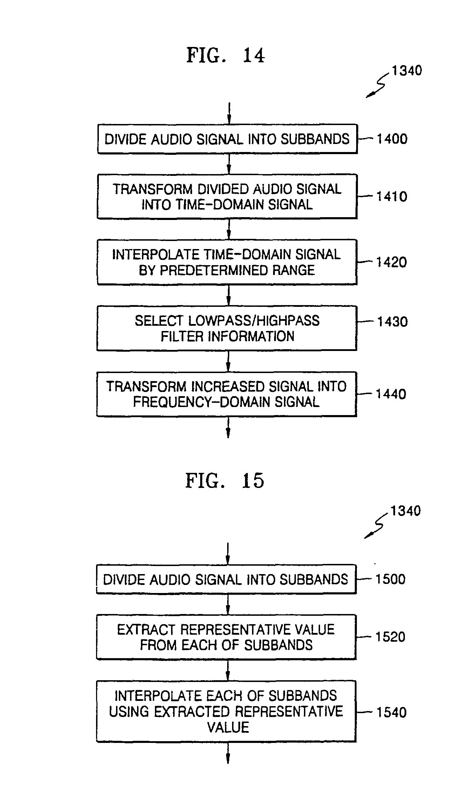

FIG. 14 is a flowchart showing an example of operation 1340 shown in FIG. 13.

In operation 1400, the frequency-domain audio signal input through operation 1300 is divided into subbands.

In operation 1410, the audio signal divided into subbands is transformed into a time-domain audio signal corresponding to each of the subbands.

In operation 1420, the time-domain audio signal is received, and the signal decimated by a predetermined range in operation 630 of FIG. 6 is interpolated by the decimated range. The interpolation is performed by using a parameter previously set in a low bitrate audio decoding system or additional information in a bitstream received from a low bitrate audio encoding system. For example, since the reference or detailed signal is reduced by half in FIG. 6, the time-domain signal is increased by double in operation 1420. While the example in FIG. 14 illustrates a time-domain signal interpolated by double, the interpolation range of a time-domain signal may be differently set. In addition, the interpolation may be performed using additional information of an interpolation factor in operation 1420.

In operation 1430, it is detected whether the time-domain audio signal input through operation 1420 is the reference signal composed of low frequency components within the time-domain audio signal, or the detailed signal composed of high frequency components within the time-domain audio signal. By means of additional information, it is detected whether it is a reference signal or a detailed signal.

In operation 1440, the reference or detailed signal is input through operation 1430, and the input time-domain audio signal is transformed into a frequency-domain signal.

FIG. 15 is a flowchart showing another example of operation 1340 shown in FIG. 13.

In operation 1500, a frequency-domain audio signal input through operation 1300 of FIG. 13 is divided into subbands.

In operation 1520, a representative value is extracted from the audio signal divided into subbands.

In operation 1540, frequency components are interpolated into each of the subbands divided in operation 1500 using a representative value input through operation 1520. Referring to the example in FIG. 4, in case of selecting a representative value for five frequency components in each of the subbands, four unselected frequency components in each of the subbands may be set to have the same value as the representative value. In addition, the four unselected frequency components may be differently interpolated depending on distances from the frequency component having the representative value. The representative value may be determined to be the maximum value or the mean value of frequency components.

While the example in FIG. 15 illustrates an audio signal, the frequency component processor unit 110 can handle a data signal including an image signal as well as an audio signal by using the aforementioned constructions.

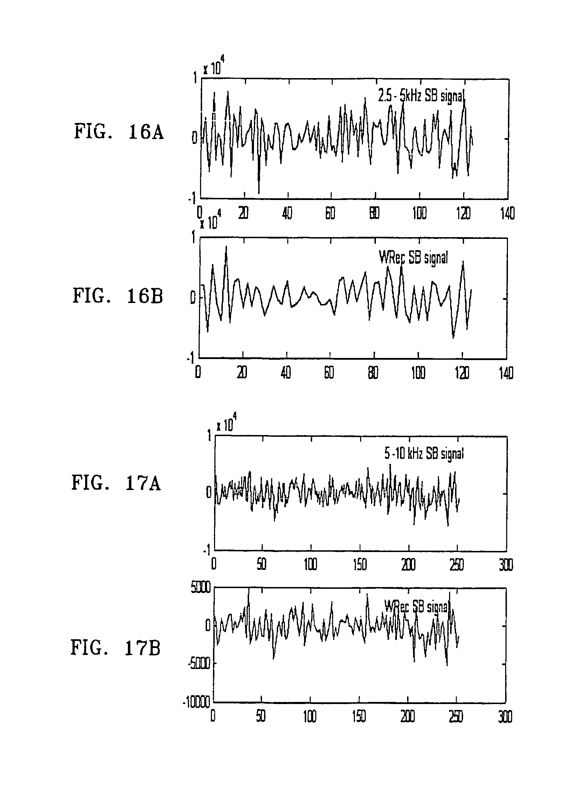

FIGS. 16A and 16B show an example of an audio signal for a predetermined subband in an encoding operation and in a decoding operation, respectively.

FIG. 16A shows an audio signal in a range of 2.5 to 5kHz in an encoding operation, and FIG. 16B shows an audio signal in a range of 2.5 to 5kHz in a decoding operation.

FIGS. 17A and 17B show another example of an audio signal for a predetermined subband in an encoding operation and in a decoding operation, respectively.

FIG. 17A shows an audio signal in a range of 5 to 10kHz in an encoding operation, and FIG. 17B shows an audio signal in a range of 5 to 10kHz in a decoding operation.

The present invention can be recorded on computer-readable recording media with computer-readable codes. Examples of the computer include all kinds of apparatuses with an information processing function. Examples of the computer-readable recording media include all kinds of recording devices for storing computer-readable data, such as ROM, RAM, CD-ROM, magnetic tape, floppy disk, optical data storage system, etc.

While the present invention has been described with reference to exemplary embodiments thereof, it will be understood by those skilled in the art that various changes in form and details may be made therein without departing from the scope of the present invention as defined by the following claims.

There is provided a low-bitrate encoding/decoding method and system. According to the present invention, it is possible to efficiently compress data at a low bitrate and thus provide a high quality audio signal in storing and recovering audio signals in a variety of audio systems, such as Digital Audio Broadcasting (DAB), internet phone, and Audio on Demand (AOD), and multimedia systems including software. In addition, it is possible to provide a encoding/decoding method and system that can efficiently compress data signals including image signals as well as audio signals.

## Claims

1. A low-bitrate encoding system comprising:
a time-frequency transform unit (100) arranged to transform an input time-domain audio signal into a frequency-domain audio signal;
a subband division unit (400) arranged to divide the frequency-domain audio signal into subbands;
a representative value extraction information unit (420) arranged to retrieve information for extracting a representative value for a number of frequency components of each of the subbands; and
a representative value extracting unit (440) arranged to extract the representative value for the number of frequency components of each of the subbands according to the representative value extraction information.

2. The system of claim 1, wherein the representative value extraction information includes information on the number of frequency components in each of the subbands used to extract the representative value.

3. The system of claim 1, wherein the representative value extraction information includes information on the amplitude of a frequency component to be extracted as the representative value from among the frequency components in each of the subbands.

4. The system of claim 1, wherein the input time-domain signal further includes of image signals.

5. A low-bitrate encoding method comprising:
transforming an input time-domain audio signal into a frequency-domain audio signal;
dividing the frequency-domain audio signal into subbands;
retrieving information for extracting a representative value for a number of frequency components of each of the subbands; and
extracting the representative value for the number of frequency components of each of the subbands according to the representative value extraction information.

6. The method of claim 5, wherein the representative value extraction information includes at least any one of information on the number of frequency components in each of the subbands used to extract the representative value and information on the amplitude of a frequency component to be extracted as the representative value from among the frequency components in each of the subbands.

7. The method of claim 5 or 6, wherein the data signal includes at least one of audio and image signals.

8. A low-bitrate decoding system comprising:
a subband division unit arranged to divide a losslessly decoded frequency-domain audio signal into subbands;
a representative value extracting unit arranged to extract a representative value for a number of frequency components of each of the subbands; and
an interpolation unit arranged to interpolate values for the number of frequency components of each of the subbands by using the extracted representative value.

9. The system of claim 8, wherein the interpolation unit is arranged to perform an interpolating operation using location information between a frequency component where the representative value is located and a frequency component to be interpolated in each of the subbands.

10. The system of claim 8, wherein the data signal includes at least one of audio and image signals.

11. A low-bitrate decoding method comprising:
dividing a losslessly decoded frequency-domain audio signal into subbands;
extracting a representative value for a number of frequency components of each of the subbands; and
interpolating values for the number of frequency components of each of the subbands by using the extracted representative value.

12. The method of claim 11, wherein the data signal includes at least one of audio and image signals.

13. A computer-readable recording medium having embedded thereon a computer program adapted to perform the method of any of claims 5 to 7 or 11 or 12.

## Patentansprüche

1. Kodiersystem mit niedriger Bitrate umfassend:
eine Zeit-Frequenz-Transformationseinheit (100), die so ausgebildet ist, dass sie ein eingegebenes Audiosignal im Zeitbereich in ein Audiosignal im Frequenzbereich transformiert,
eine Unterbanddivisionseinheit (400), die so ausgebildet ist, dass sie das Audiosignal im Frequenzbereich in Unterbänder unterteilt,
eine Extraktionsinformationseinheit (420) für einen repräsentativen Wert, die so ausgebildet ist, dass sie Information zum Extrahieren eines repräsentativen Werts für eine Anzahl an Frequenzkomponenten in jedem der Unterbänder abruft, und
eine Extraktionseinheit (440) für einen repräsentativen Wert, die so ausgebildet ist, dass sie den repräsentativen Wert für die Anzahl an Frequenzkomponenten in jedem der Unterbänder gemäß der Extraktionsinformation des repräsentativen Werts extrahiert.

2. System nach Anspruch 1, wobei die Extraktionsinformation des repräsentativen Werts Informationen zur Anzahl an Frequenzkomponenten in jedem der Unterbänder beinhaltet, die zum Extrahieren des repräsentativen Werts verwendet werden.

3. System nach Anspruch 1, wobei die Extraktionsinformation des repräsentativen Werts Informationen zur Amplitude einer Frequenzkomponente beinhaltet, die als der repräsentative Wert aus den Frequenzkomponenten in jedem der Unterbänder zu extrahieren sind.

4. System nach Anspruch 1, wobei das eingegebene Signal im Zeitbereich ferner Bildsignale beinhaltet.

5. Kodierverfahren mit niedriger Bitrate umfassend:
Transformieren eines eingegebenen Audiosignals im Zeitbereich in ein
Audiosignal im Frequenzbereich,
Unterteilen des Audiosignals im Frequenzbereich in Unterbänder,
Abrufen von Informationen zum Extrahieren eines repräsentativen Werts für eine Anzahl an Frequenzkomponenten in jedem der Unterbänder und
Extrahieren des repräsentativen Werts für die Anzahl an Frequenzkomponenten in jedem der Unterbänder gemäß der Extraktionsinformation des repräsentativen Werts.

6. Verfahren nach Anspruch 5, wobei die Extraktionsinformation des repräsentativen Werts Informationen zur Anzahl an Frequenzkomponenten in jedem der Unterbänder, die zum Extrahieren des repräsentativen Werts verwendet wurden, und/oder Informationen zur Amplitude einer Frequenzkomponente beinhaltet, die als der repräsentative Wert aus den Frequenzkomponenten in jedem der Unterbänder zu extrahieren sind.

7. Verfahren nach Anspruch 5 oder 6, wobei das Datensignal Audiosignale und/oder Bildsignale beinhaltet.

8. Dekodiersystem mit niedriger Bitrate umfassend:
eine Unterbanddivisionseinheit, die so ausgebildet ist, dass sie ein verlustlos dekodiertes Audiosignal im Frequenzbereich in Unterbänder unterteilt,
eine Extraktionseinheit für einen repräsentativen Wert, die so ausgebildet ist, dass sie einen repräsentativen Wert für eine Anzahl an Frequenzkomponenten in jedem der Unterbänder extrahiert, und
eine Interpolationseinheit, die so ausgebildet ist, dass sie Werte für die Anzahl an Frequenzkomponenten in jedem der Unterbänder unter Verwendung des extrahierten repräsentativen Werts interpoliert.

9. System nach Anspruch 8, wobei die Interpolationseinheit so ausgebildet ist, dass sie einen Interpolationsvorgang unter Verwendung von Lageinformation zwischen einer Frequenzkomponente, bei der der repräsentative Wert gelegen ist, und einer zu interpolierenden Frequenzkomponente in jedem der Unterbänder durchführt.

10. System nach Anspruch 8, wobei das Datensignal Audiosignale und/oder Bildsignale beinhaltet.

11. Dekodierverfahren mit niedriger Bitrate umfassend:
Unterteilen eines verlustlos dekodierten Audiosignals im Frequenzbereich in Unterbänder,
Extrahieren eines repräsentativen Werts für eine Anzahl an Frequenzkomponenten in jedem der Unterbänder, und
Interpolieren von Werten für die Anzahl an Frequenzkomponenten in jedem der Unterbänder unter Verwendung des extrahierten repräsentativen Werts.

12. Verfahren nach Anspruch 11, wobei das Datensignal Audiosignale und/oder Bildsignale beinhaltet.

13. Computerlesbares Aufzeichnungsmedium mit einem darauf enthaltenen Computerprogramm, das dazu ausgebildet ist, das Verfahren nach einem der Ansprüche 5 bis 7 oder 11 bis 12 durchzuführen.

## Revendications

1. Système d'encodage à faible débit binaire, comprenant :
une unité de transformation de temps - fréquence (100) conçue pour transformer un signal audio d'entrée de domaine temporel en un signal audio de domaine de fréquence ;
une unité de division en sous-bandes (400) conçue pour diviser le signal audio de domaine de fréquence en sous-bandes ;
une unité d'information d'extraction de valeur représentative (420) conçue pour récupérer des informations pour extraire une valeur représentative pour un nombre de composantes de fréquence de chacune des sous-bandes ; et
une unité d'extraction de valeur représentative (440) conçue pour extraire la valeur représentative pour le nombre de composantes de fréquence de chacune des sous-bandes sur la base des informations d'extraction de valeur représentative.

2. Système selon la revendication 1, dans lequel les informations d'extraction de valeur représentative comprennent des informations sur le nombre de composantes de fréquence dans chacune des sous-bandes utilisées pour extraire la valeur représentative.

3. Système selon la revendication 1, dans lequel les informations d'extraction de valeur représentative comprennent des informations sur la grandeur d'une composante de fréquence à extraire comme valeur représentative parmi les composantes de fréquence dans chacune des sous-bandes.

4. Système selon la revendication 1, dans lequel le signal d'entrée de domaine temporel comprend en outre des signaux d'image.

5. Procédé d'encodage à faible débit binaire, comprenant les étapes suivantes :
transformer un signal audio d'entrée de domaine temporel en un signal audio de domaine de fréquence ;
diviser le signal audio de domaine de fréquence en sous-bandes ;
récupérer des informations pour extraire une valeur représentative pour un nombre de composantes de fréquence de chacune des sous-bandes ; et
extraire la valeur représentative pour le nombre de composantes de fréquence de chacune des sous-bandes sur la base des informations d'extraction de valeur représentative.

6. Procédé selon la revendication 5, dans lequel les informations d'extraction de valeur représentative comprennent au moins soit des informations sur le nombre de composantes de fréquence dans chacune des sous-bandes utilisées pour extraire la valeur représentative, soit des informations sur la grandeur d'une composante de fréquence à extraire comme valeur représentative parmi les composantes de fréquence dans chacune des sous-bandes

7. Procédé selon la revendication 5 ou 6, dans lequel le signal de données comprend au moins soit des signaux audio, soit des signaux d'image.

8. Système de décodage à faible débit binaire, comprenant :
une unité de division en sous-bandes conçue pour diviser un signal audio de domaine de fréquence décodé sans perte en sous-bandes ;
une unité d'extraction de valeur représentative conçue pour extraire une valeur représentative pour un nombre de composantes de fréquence de chacune des sous-bandes ; et
une unité d'interpolation conçue pour interpoler des valeurs pour le nombre de composantes de fréquence de chacune des sous-bandes en utilisant la valeur représentative extraite.

9. Système selon la revendication 8, dans lequel l'unité d'interpolation est conçue pour exécuter une opération d'interpolation en utilisant des informations de localisation entre une composante de fréquence où la valeur représentative est située et une composante de fréquence à interpoler dans chacune des sous-bandes.

10. Système selon la revendication 8, dans lequel le signal de données comprend au moins soit des signaux audio, soit des signaux d'image.

11. Procédé de décodage à faible débit binaire, comprenant les étapes suivantes :
diviser un signal audio de domaine de fréquence décodé sans perte en sous-bandes ;
extraire une valeur représentative pour un nombre de composantes de fréquence de chacune des sous-bandes ; et
interpoler des valeurs pour le nombre de composantes de fréquence de chacune des sous-bandes en utilisant la valeur représentative extraite.

12. Procédé selon la revendication 11, dans lequel le signal de données comprend au moins soit des signaux audio, soit des signaux d'image.

13. Support d'enregistrement lisible par ordinateur incorporant un programme d'ordinateur adapté pour exécuter le procédé selon l'une quelconque des revendications 5 à 7 ou 11 ou 12.
